**Europäisches Patentamt**

(19) **European Patent Office**

**Office européen des brevets**

(11) Numéro de publication: **0 107 884**
**B1**

(12) **FASCICULE DE BREVET EUROPEEN**

(45) Date de publication du fascicule du brevet: **09.03.88**

(21) Numéro de dépôt: **83201528.3**

(22) Date de dépôt: **25.10.83**

(51) Int. Cl.⁴: **G 01 R 23/02,** G 01 R 19/04, H 03 D 3/00, H 04 N 11/18

(54) **Circuit numérique de mesure de la fréquence instantanée d'un signal modulé ou non en fréquence, ainsi que récepteur de télévision ou de radio équipé d'un tel circuit.**

(30) Priorité: **29.10.82 FR 8218254**

(43) Date de publication de la demande:
**09.05.84 Bulletin 84/19**

(45) Mention de la délivrance du brevet:
**09.03.88 Bulletin 88/10**

(84) Etats contractants désignés:
**BE DE FR GB IT**

(56) Documents cités:
**EP-A-0 046 103**
**EP-A-0 058 050**
**DE-A-3 030 853**
**FR-A- 248 574**

**ARCHIV FÜR ELEKTRONIK UND ÜBERTRAGUNGSTECHNIK, vol.36, no.7/8, juillet/aou7t 1982, pages 292-298, Würzburg, DE; K.-D. KAMMEYER: "Ein Verfahren zur digitalen Demodulation frequenzmodulierter Signale"**

(73) Titulaire: **Laboratoires d'Electronique et de Physique Appliquée L.E.P.**
**3, Avenue Descartes**
**F-94450 Limeil-Brévannes (FR)**
㊳ **FR**

(73) Titulaire: **N.V. Philips' Gloeilampenfabrieken**
**Groenewoudseweg 1**
**NL-5621 BA Eindhoven (NL)**
㊴ **BE DE GB IT**

(72) Inventeur: **Le Floch, Gérard**
**Société Civile S.P.I.D. 209 rue de l'université**
**F-75007 Paris (FR)**

(74) Mandataire: **Landousy, Christian et al**
**Société Civile S.P.I.D. 209, Rue de l'Université**
**F-75007 Paris (FR)**

Courier Press, Leamington Spa, England.

## Description

La présente invention concerne un circuit numérique de mesure de la fréquence instantanée $F_S$ d'un signal modulé en fréquence à partir du déphasage $\varphi$ en fonction duquel ladite fréquence instantanée est exprimée par une relation de dépendance de type trigonométrique, ledit circuit comprenant notamment deux premier et deuxième registres prévus en série pour qu'à chaque instant d'échantillonnage soient disponibles en sortie de ces registres et à l'entrée du premier des échantillons successifs $x_n$, $x_{n+1}$ et $x_{n+2}$ respectivement, et d'autre part des moyens pour déterminer l'expression $\cos \varphi = (x_n + x_{n+2})/2x_{n+1}$.

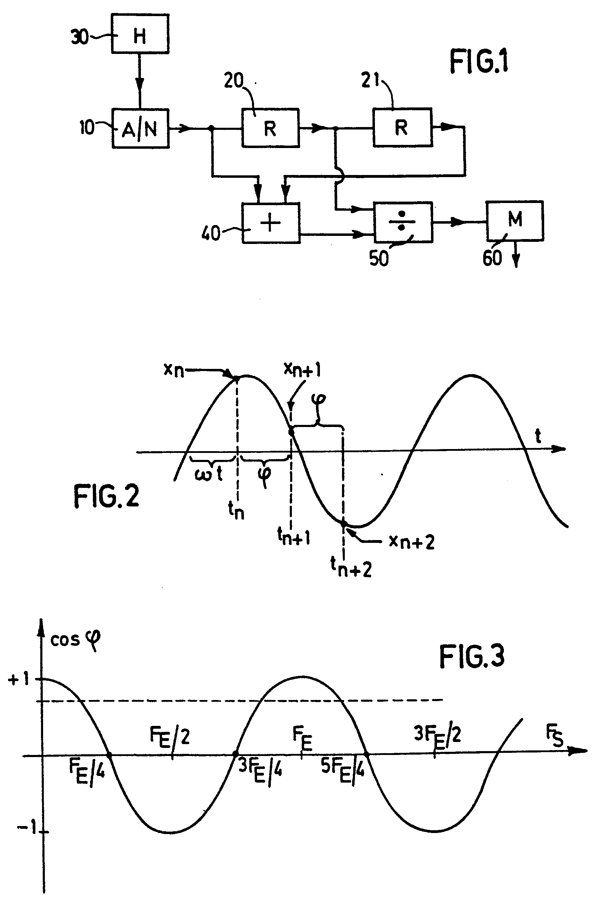

Le circuit de mesure de fréquence instantanée représenté sur la figure 1 dans le cas d'un signal de type sinusoïdal, à fréquence constante, tel que le montre la figure 2 où ont été portés trois instants d'échantillonnage $t_n$, $t_{n+1}$, $t_{n+2}$, comprend, à la suite d'un convertisseur analogique-numérique 10 qui reçoit le signal d'entrée analogique modulé en fréquence et délivre un signal numérique correspondant composé d'échantillons successifs $x_i$ de ce signal d'entrée, des registres en série, ici deux registres 20 et 21, qui reçoivent également les échantillons successifs $x_i$ au rythme de la fréquence d'échantillonnage constante fixée par un circuit d'horloge 30. A l'instant $t_{n+2}$, on a donc en sortie du registre 21 l'échantillon $x_n$, en sortie du registre 20 l'échantillon suivant $x_{n+1}$, et en sortie du registre de sortie du convertisseur 10 l'échantillon suivant $x_{n+2}$. Les échantillons $x_n$ et $x_{n+2}$ sont envoyés vers les deux entrées d'un additionneur 40 dont la sortie est reliée à la première entrée d'un diviseur 50, dont la deuxième entrée reçoit, après décalage d'un bit pour une multiplication par deux, l'échantillon $x_{n+1}$ et dont la sortie est reliée à une mémoire 60. Cette mémoire délivre un signal numérique qui est proportionnel à la fréquence instantanée du signal d'entrée modulé en fréquence.

En effet, si l'expression générale du signal analogique d'entrée est du type $x = a \sin \omega t$ (voir la figure 2), les signaux numériques en sortie des registres 21 et 20 et du registre de sortie du convertisseur ont respectivement pour expression, à fréquence d'échantillonnage constante tel que le montre la figure 2:

$$x_n = a \sin \omega t \tag{1}$$

$$x_{n+1} = a \sin (\omega t + \varphi) \tag{2}$$

$$x_{n+2} = a \sin (\omega t + 2\varphi) \tag{3}$$

L'addition de $x_n$ et $x_{n+2}$ duns l'additionneur 40 conduit à l'expression:

$$x_n + x_{n+2} = a[\sin \omega t + \sin (\omega t + 2\varphi)] \tag{4}$$

ou

$$x_n + x_{n+2} = 2a \cdot \sin(\omega t + \varphi) \cdot \cos \varphi \tag{5}$$

ou encore

$$x_n + x_{n+2} = 2x_{n+1} \cdot \cos\varphi \tag{6}$$

De l'expression (6), il vient:

$$\cos \varphi = \frac{x_n + x_{n+2}}{2x_{n+1}} \tag{7}$$

Par ailleurs, il est évident que le déphasage $\varphi$ est égal à:

$$\varphi = 2\pi \frac{F_S}{F_E} \tag{8}$$

où $F_E$ est la fréquence d'échantillonnage, que l'on a choisie constante, et $F_S$ la fréquence du signal modulé. On obtient donc, si C est un coefficient constant égale à $F_E/2\pi$:

$$F_S = \frac{F_E \cdot \text{Arc} \cos \varphi}{2\pi} = C \cdot \text{Arc} \cos \varphi \tag{9}$$

Le tracé de la courbe $\cos \varphi = f(F_S)$ montre alors (voir la figure 3) qu'il existe bien entendu, pour une valeur déterminée de $\cos \varphi$, plusieurs valeurs de Arc $\cos \varphi$, ce qui conduit à plusieurs valeurs de $F_S$; mais la simple connaissance de la gamme de fréquence dans laquelle on opère permet de lever cette ambiguïté et de sélectionner la valeur de $F_S$ cherchée.

Un circuit du type qui vient d'être décrit est connu de la demande de brevet allemand DE—A—3030853. Avec de tels circuits, on constate donc qu'à partir de trois mesures consécutives faites à intervalles réguliers, on a pu connaître la fréquence instantanée d'un signal de type sinusoïdal, l'ambiguïté sur la gamme de fréquence étant levée, selon les cas, soit par la détermination du signe de la pente de la courbe

cos $\phi = f(F_s)$ s'il s'agit de deux domaines de fréquence consécutifs, soit par le type d'application lui-même comme on vient de le dire, soit encore par un moyen de comptage. On peut remarquer d'une part la simplicité de cette détermination de fréquence, mais surtout le fait qu'elle est absolument indépendante de l'amplitude, comme le montre notamment l'expression (7) où l'amplitude $a$ n'est plus présente. Cependant, si cette amplitude devient trop faible, on ne dispose plus d'information à traiter.

Le but de l'invention est donc de proposer un circuit tel que défini dans le premier paragraphe, mais avec lequel il soit possible d'effectuer une détermination, qui peut même être approximative, de l'amplitude, et de prévoir ensuite un circuit de contrôle automatique de gain.

A cet effet, le circuit selon l'invention est, dans un premier mode de réalisation, caractérisé en ce qu'il comprend, pour permettre la mise en place d'un circuit de contrôle automatique de gain, un circuit de détermination d'amplitude composé:

d'un premier et d'un deuxième élévateur au carré respectivement de la sortie $x_{n+1}$ du premier registre et de la sortie d'un additionneur des échantillons $x_n$ et $x_{n+2}$;

d'un premier multiplieur de la sortie $x_n$ du deuxième registre par l'entrée $x_{n+2}$ du premier registre;

d'un premier soustracteur retranchant la sortie du premier multiplieur de celle du premier élévateur au carré;

d'un deuxième multiplieur de la sortie dudit premier élévateur au carré, après décalage de deux bits de celle-ci pour multiplication par 4, par la sortie du premier soustracteur;

d'un deuxième soustracteur retranchant la sortie du premier élévateur au carré, après décalage de deux bits de celle-ci pour multiplication par 4, de celle du deuxième élévateur au carré;

et d'un diviseur de la sortie du deuxième multiplieur par la sortie du deuxième soustracteur, ce diviseur délivrant le carré de ladite amplitude du signal d'entrée.

Une autre réalisation avantageuse de l'invention consiste en un circuit caractérisé en ce qu'il comprend, pour permettre la mise en place d'un circuit de contrôle automatique de gain, un circuit de détermination d'amplitude composé:

d'un multiplieur à deux séries d'entrées composées, l'une, des entrées $x_n$, $x_{n+1}$, $(x_n+x_{n+2})$, $(x^2_{n+1}-x_n \cdot x_{n+2})$, et, l'autre, des entrées $x_{n+1}$, $x_{n+2}$, $(x_n+x_{n+2})$, $x^2_{n+1}$, et à quatre sorties $x^2_{n+1}$, $x_n \cdot x_{n+2}$, $(x_n+x_{n+2})^2$ et $4x^2_{n+1} \cdot (x^2_{n+1}-x_n \cdot x_{n+2})$ fournies par multiplexage et stockées dans quatre registres intermédiaires;

d'un premier soustracteur de calcul de $(x^2_{n+1}-x_n \cdot x_{n+2})$;

d'un deuxième soustracteur de calcul de $4x^2_{n+1}-(x_n+x_{n+2})^2$;

et d'un diviseur de la sortie du quatrième registre intermédiaire par la sortie du deuxième soustracteur, ce diviseur délivrant la carré de ladite amplitude du signal d'entrée.

Dans un troisième mode de réalisation également intéressant, le circuit selon l'invention est cette fois caractérisé en ce qu'il comprend, pour permettre la mise en place d'un circuit de contrôle automatique de gain, un circuit de détermination d'amplitude composé:

de trois registres supplémentaires délivrant respectivement $x_{n+2}$, $x_{n+1}$, $x_n$;

d'un premier multiplieur de calcul de $x_n \cdot x_{n+2}$;

d'un élévateur au carré de la sortie $x_{n+1}$ du deuxième registre supplémentaire;

d'un soustracteur de calcul de $(x^2_{n+1}-x_n \cdot x_{n+2})$;

d'une mémoire de correspondance recevant la sortie cos $\phi$ pour déterminer $1/\sin^2 \phi$ à partir de chaque valeur de cos $\phi$;

et d'un deuxième multiplieur de la sortie du soustracteur par celle de la mémoire de correspondance, ce deuxième multiplieur délivrant le carrée de ladite amplitude du signal d'entrée.

Les particularités et avantages de l'invention apparaîtront maintenant de façon plus détaillée dans la description qui suit et dans les dessins annexés, donnés à titre d'exemples non limitatifs et dans lesquels:

la figure 1 montre un exemple de réalisation d'un circuit numérique de démodulation de fréquence de type connu;

la figure 2 montre l'échantillonnage d'un signal de type sinusoïdal, à fréquence constante et à trois instants $t_n$, $t_{n+1}$, $t_{n+2}$;

la figure 3 représente l'allure de la courbe cos $\phi = f(F_s)$ où $\phi$ correspond à l'intervalle d'échantillonnage en radians et où $F_s$ est la fréquence du signal (modulé ou non);

les figures 4 à 6 montrent trois modes de réalisation du circuit selon l'invention.

A partir des expression (1), (2), (3) données plus haut, on arrive à exprimer l'amplitude du signal simplement en fonction de $x_n$, $x_{n+1}$, $x_{n+2}$:

$$a^2 = \frac{4x^2_{n+1} \ (x^2_{n+1}-x_n \cdot x_{n+2})}{(2x_{n+1}-x_n-x_{n+2})(2x_{n+1}+x_n+x_{n+2})} \qquad (10)$$

ou encore:

$$a^2 = \frac{4x^2_{n+1} \ (x^2_{n+1}-x_n \cdot x_{n+2})}{4x^2_{n+1}-(x_n+x_{n+2})^2} \cdot \qquad (11)$$

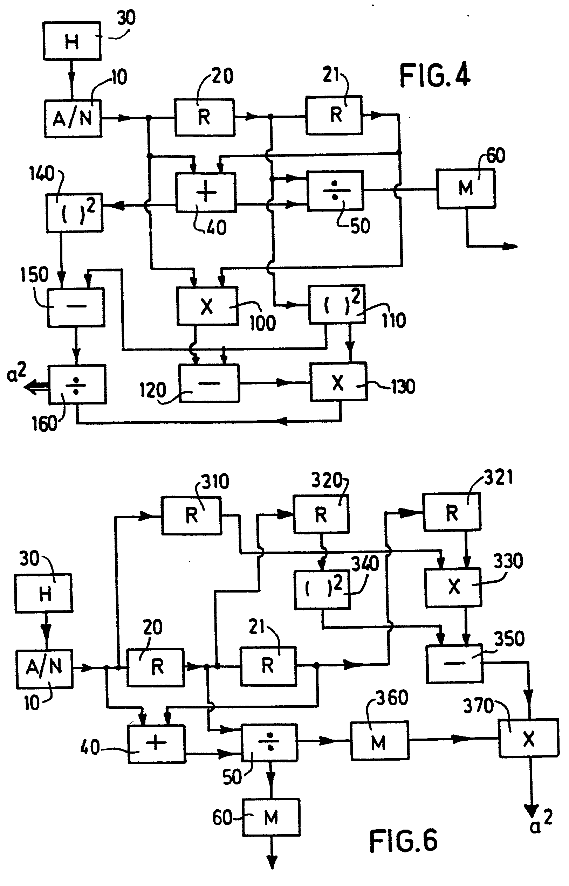

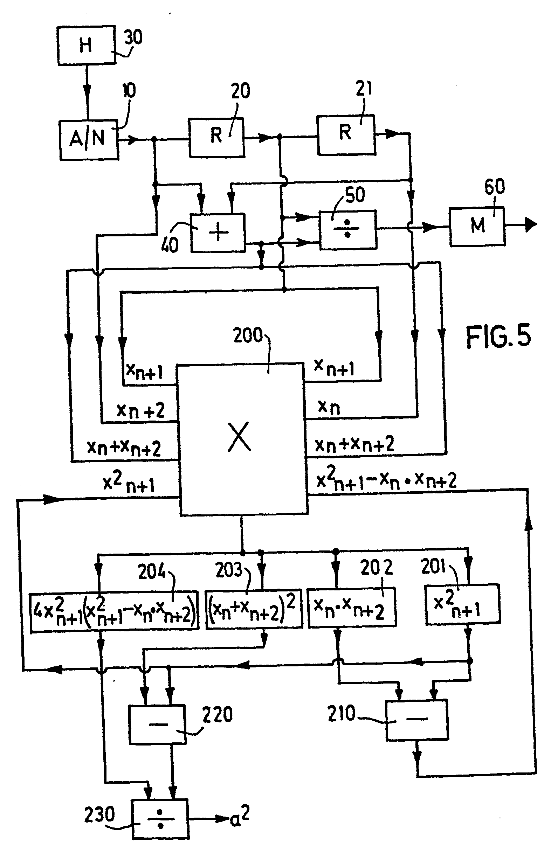

Le circuit numérique de mesure de fréquence instantanée selon l'invention comprend alors, pour la

détermination de $a^2$ selon l'expression (11), les éléments supplémentaires suivants (voir la figure 4, par rapport à la figure 1):

un premier multiplieur 100 recevant l'échantillon $x_n$ de sortie du registre 21 et l'échantillon $x_{n+2}$ de sortie du registre de sortie du convertisseur 10 et délivrant l'expression $x_n \cdot X_{n+2}$;

un premier élévateur au carré 110 de la sortie $x_{n+1}$ du registre 20;

un soustracteur 120 recevant d'une part la sortie de l'élévateur au carré 110 et d'autre part la sortie du premier multiplieur 100 et délivrant l'expression $(x_{n+1}^2 - x_n \cdot x_{n+2})$;

un deuxième multiplieur 130 recevant la sortie de l'élévateur au carré 100, après décalage de deux bits pour une multiplication part 4, et la sortie du soustracteur 120 et délivrant l'expression $4x_{n+1}^2 \cdot (x_{n+1}^2 - x_n \cdot x_{n+2})$ qui est le numérateur de l'expression (11) du carré de l'amplitude;

un deuxième élévateur au carré 140 de la sortie de l'additionneur 40;

un soustracteur 150) recevant d'une part la sortie de l'élévateur au carré 110 (après le même décalage de deux bits que précédemment, pour une multiplication par 4) et d'autre part la sortie du deuxième élévateur au carré 140 et délivrant l'expression $4x_{n+1}^2 \cdot (x_n + x_{n+2})^2$ qui est le dénominateur de l'expression (11);

un diviseur 160 de la sortie du deuxième multiplicateur 130 par la sortie du soustracteur 150, délivrant le carré de l'amplitude cherchée.

On notera ici que les élévations au carré peuvent être faites soit par lecture de tables, soit par multiplication directe. On remarquera aussi qu'il est possible de réduire le nombre de multiplieurs et d'opérer par multiplexage pour la réalisation des multiplications. En effet, on a vu que la détermination de l'amplitude n'a pas besoin d'être faite fréquemment: d'un part elle ne varie pas beaucoup, d'autre part elle n'intervient pas dans la démodulation de fréquence et simplement ne doit pas être trop faible.

La figure 5 montre un exemple de réalisation du circuit selon l'invention où l'on opère effectivement par multiplexage, ce circuit comprenant cette fois, par rapport à la figure 1, les éléments supplémentaires suivants:

un unique multiplieur 200 présentant pour les diverses multiplications à effectuer successivement deux séries d'entrées: d'une part, dans le cas présent, les quatre entrées $x_n$, $x_{n+1}$, $(x_n + x_{n+2})$ $(x_{n+1}^2 - x_n \cdot x_{n+2})$, d'autre part les quatre entrées $x_{n+1}$, $x_{n+2}$, $(x_n + x_{n+2})$, $x_{n+1}$, ainsi que plusieurs sorties délivrant les quatre résultats des opérations intermédiaires intervenant dans le calcul de $a^2$, à savoir $x_{n+1}^2$, $x_n \cdot x_{n+2}$, $(x_n + x_{n+2})^2$, et $4x_{n+1}^2 \cdot (x_{n+1}^2 - x_n \cdot x_{n+2})$, résultats qui sont stockés dans des registres 201 à 204;

un premier soustracteur 210 intervenant dans ces opérations intermédiaires pour le calcul de l'expression $x_{n+1}^2 - x_n \cdot x_{n+2}$ à partir des sorties des registres 201 et 202, la sortie de ce soustracteur étant envoyée vers l'une des deux séries d'entrée du multiplieur pour le calcul du numérateur de l'expression (11);

un deuxième soustracteur 220 recevant d'une part la sortie $x_{n+1}^2$ du registre 201 (avec décalage de deux bits pour obtenir $4x_{n+1}^2$) et d'autre part la sortie $(x_n + x_{n+2})^2$ du registre 203, et délivrant l'expression du dénominateur de l'expression (11);

un diviseur 230 de la sortie du registre 204 par la sortie du soustracteur 220, délivrant le carré de l'amplitude cherchée.

Bien entendu, la présente invention n'est pas limitée aux modes de réalisation qui viennent d'être décrits et représentés et à partir desquels d'autres variantes peuvent encore être proposées sans pour cela sortir du cadre de l'invention.

En particulier, ou peut par exemple obtenir d'autres formes équivalentes de l'expression (11) du carré de l'amplitude, expression qui s'écrit notamment, après transformations:

$$a^2 = \frac{x_{n+1}^2 - x_n \cdot x_{n+2}}{\sin^2 \phi} \qquad (12)$$

Le circuit de démodulation selon l'invention comprend alors, pour la détermination de $a^2$ selon cette nouvelle expression (12), les éléments supplémentaires suivants (voir la figure 6, par rapport à la figure 1):

des registres 310, 320, 321 prélevant les échantillons successifs en sortie du registre de sortie du convertisseur 10 et des registres 20 et 21 pour permettre la réalisation à vitesse plus lente des opérations nécessaires dans le circuit de détermination d'amplitude;

un premier multiplieur 330 délivrant l'expression $x_n \cdot x_{n+2}$;

un élévateur au carré 340 de la sortie $x_{n+1}$;

un soustracteur 350 recevant d'une part la sortie de l'élévateur au carré 340 et d'autre part la sortie du premier multiplieur 330 et délivrant l'expression $(x_{n+1}^2 - x_n \cdot x_{n+2})$;

une mémoire 360 recevant la sortie $\cos \phi$ et servant de table pour délivrer la valeur correspondant de $1/\sin^2 \phi$;

un deuxième multiplieur 370 recevant la sortie du soustracteur 350 et la sortie de la mémoire 360 et délivrant l'expression du carré de l'amplitude cherchée.

Là encore, si l'amplitude ne varie pas trop rapidement, on peut supprimer les éléments 330, 340, 370,

4

pour les remplacer par un seul multiplieur opérant par multiplexage de la même manière que précédemment.

Par ailleurs, d'autres transformations mathématiques de l'expression du carré de l'amplitude conduisent à la forme suivante:

$$a^2 = \frac{x_n^2 + x_{n+1}^2 - 2x_n \cdot x_{n+1} \cdot \cos\phi}{\sin^2\phi} \qquad (13)$$

La réalisation du circuit de démodulation comprend alors, pour la nouvelle détermination de $a^2$ selon (13), les éléments supplémentaires suivants (toujours par rapport aux éléments de base prévus sur la figure 1): deux registres prélevant les échantillons successifs $x_n$ et $x_{n+1}$ en sortie des registres 21 et 20, deux élévateurs au carré pour le calcul, à partir du contenu de ces deux registres, de $x_n^2$ et $x_{n+1}^2$, deux multiplieurs (l'un pour le calcul de $x_n \cdot x_{n+1}$, l'autre pour le calcul de $2x_n \cdot x_{n+1} \cdot \cos \phi$, avec décalage d'un bit pour la multiplication par deux), un additionneur de $x_n^2$ et $x_{n+1}^2$, un soustracteur de $(x_n^2 + x_{n+1}^2)$ et de $2x_n x_{n+1} \cos \phi$, une mémoire des valeurs de $1/\sin^2\phi$ correspondant à celles de $\cos \phi$ délivrées par le diviseur 50, et un multiplieur de la sortie du soustracteur par celle de cette mémoire.

On peut vérifier que l'expression (13) reste valable pour deux échantillons $x_n$ et $x_p$ qui ne sont plus successifs, et entre lesquels le déphasage est exprimée par la valeur $(p-n) \phi$; l'expression du carré de l'amplitude prend alors une forme tout à fait semblable à (13):

$$a^2 = \frac{x_n^2 + x_p^2 - 2x_n \cdot x_p \cdot \cos \left[(p-n)\phi\right]}{\sin^2 \left[(p-n)\phi\right]} \qquad (14)$$

expression (14) à laquelle correspond un circuit de détermination d'amplitude tout à fait similaire à celui prévu pour la détermination de $a^2$ selon l'expression (13).

**Revendications**

1. Circuit numérique de mesure de la fréquence instantanée $F_s$ d'un signal modulé en fréquence à partir du déphasage $\phi$ en fonction duquel ladite fréquence instantanée est exprimée par une relation de dépendance de type trigonomètrique, ledit circuit comprenant notamment deux premier et deuxième registres (20) et (21) prévus en série pour qu'à chaque instant d'échantillonnage soient disponibles en sortie de ces registres (21) et (20) et à l'entrée (10) du premier des échantillons successifs $x_n$, $x_{n+1}$ et $x_{n+2}$ respectivement, et d'autre part des moyens pour déterminer l'expression $\cos \phi = (x_n + x_{n+2})/2x_{n+1}$, caractérisé en ce qu'il comprend, pour permettre la mise en place d'un circuit de contrôle automatique de gain, un circuit de détermination d'amplitude composé:

d'un premier et d'un deuxième élévateur au carré (110) et (140) respectivement de la sortie $x_{n+1}$ du premier registre (20) et de la sortie d'un additionneur (40) des échantillons $x_n$ et $x_{n+2}$;

d'un premier multiplieur (100) de la sortie $x_n$ du deuxième registre (21) par l'entrée $x_{n+2}$ du premier registre (20);

d'un premier soustracteur (120) retranchant la sortie du premier multiplieur (100) de celle du premier élévateur au carré (110);

d'un deuxième multiplieur (130) de la sortie dudit premier élévateur au carré (110), après décalage de deux bits de celle-ci pour multiplication par 4, par la sortie du premier soustracteur (120);

d'un deuxième soustracteur (150) retranchant la sortie du premier élévateur au carré (110), après décalage de deux bits de celle-ci pour multiplication par 4, de cell du deuxième élévateur au carré (140);

et d'un diviseur (160) de la sortie du deuxième multiplieur (130) par la sortie du deuxième soustracteur (150), ce diviseur délivrant le carré de ladite amplitude du signal d'entrée.

2. Circuit numérique de mesure de la fréquence instantanée $F_s$ d'un signal modulé en fréquence à partir du déphasage $\phi$ en fonction duquel ladite fréquence instantanée est exprimée par une relation de dépendance de type trigonométrique, ledit circuit comprenant notamment deux premier et deuxième registres (20) et (21) prévus en série pour qu'à chaque instant d'échantillonnage soient disponibles en sortie de ces registres (21) et (20) et à l'entrée (10) du premier des échantillons successifs $x_n$, $x_{n+1}$ et $x_{n+2}$ respectivement, et d'autre part des moyens pour déterminer l'expression $\cos \phi = (x_n + x_{n+2})/2x_{n+1}$, caractérisé en ce qu'il comprend, pour permettre la mise en place d'un circuit de contrôle automatique de gain, un circuit de détermination d'amplitude composé:

d'un multiplieur (200) à deux séries d'entrées composées, l'une, des entrées $x_n$, $x_{n+1}$, $(x_n + x_{n+2})$, $(x_{n+1}^2 - x_n \cdot x_{n+2})$, et, l'autre, des entrées $x_{n+1}$, $x_{n+2}$, $(x_n + x_{n+2})$, $x_{n+1}^2$, et à quatre sorties $x_{n+1}^2$, $x_n \cdot x_{n+2}$, $(x_n + x_{n+2})^2$ et $4x_{n+1}^2 \cdot (x_{n+1}^2 - x_n \cdot x_{n+2})$ fournies par multiplexage et stockées dans quatre registres intermédiaires (201) à (204) respectivement;

d'un premier soustracteur (210) de calcul de $(x_{n+1}^2 - x_n \cdot x_{n+2})$;

d'un deuxième soustracteur (220) de calcul de $4x_{n+1}^2 - (x_n + x_{n+2})^2$;

5

et d'un diviseur (230) de la sortie du quatrième registre intermédiaire (204) par la sortie du deuxième soustracteur (220), ce diviseur délivrant le carré de ladite amplitude du signal d'entrée.

3. Circuit numérique de mesure de la fréquence instantanée $F_s$ d'un signal modulé en fréquence à partir du déphasage $\phi$ en fonction duquel ladite fréquence instantanée est exprimée par une relation de dépendance de type trigonométrique, ledit circuit comprenant notamment deux premier et deuxième registres (20) et (21) prévus en série pour qu'à chaque instant d'échantillonnage soient disponibles en sortie de ces registres (21) et (20) et à l'entrée (10) du premier des échantillons successifs $x_n$, $x_{n+1}$ et $x_{n+2}$ respectivement, et d'autre part des moyens pour déterminer l'expression cos $\phi=(x_n+x_{n+2})/2x_{n+1}$, caractérisé en ce qu'il comprend, pour permettre la mise en place d'un circuit de contrôle automatique de gain, un circuit de détermination d'amplitude composé:

de trois registres supplémentaires (310), (320), (321) délivrant respectivement $x_{n+2}$, $x_{n+1}$, $x_n$;

d'un premier multiplieur (330) de calcul de $x_n \cdot x_{n+2}$;

d'un élévateur au carré (340) de la sortie $x_{n+1}$ du deuxième registre supplémentaire (320);

d'un soustracteur (350) de calcul de $(x^2_{n+1}-x_n \cdot x_{n+2})$;

d'une mémoire de correspondance (360) recevant la sortie cos $\phi$ pour déterminer $1/\sin^2 \phi$ à partir de chaque valeur de cos $\phi$;

et d'un deuxième multiplieur (370) de la sortie du soustracteur (350) par celle de la mémoire de correspondance (360), ce deuxième multiplieur (370) délivrant le carrée de ladite amplitude du signal d'entrée.

4. Circuit selon la revendication 3, caractérisé en ce que le premcer multiplieur (330), l'élévateur au carré (340) et le deuxième multiplieur (370) sont regroupés en un unique multiplieur opérant par multiplexage.

5. Circuit selon l'une des revendications 1 à 4, caractérisé en ce que le circuit de détermination d'amplitude est composé de deux registres supplémentaires prélevant deux échantillons successifs $x_n$ et $x_{n+1}$ pour permettre une réalisation plus lente des opérations nécessaires dans le circuit de détermination d'amplitude.

6. Circuit selon l'une des revendications 1 à 4, caractérisé en ce que le circuit de détermination d'amplitude est composé de deux registres supplémentaires prélevant deux échantillons $x_n$ et $x_p$ déphasage quelconque égal à (p–n) pour permettre une réalisation plus lente des opérations nécessaires dans le circuit de détermination d'amplitude.

**Patentansprüche**

1. Digitale Anordnung zum Messen der augenblicklichen Frequenz $F_s$ eines frequenzmodulierten Signals nach der Phasenverschiebung $\phi$, in deren Abhängigkeit die genannte augenblickliche Frequenz mittels einer trigoniometrischen Abhängigkeitsbeziehung ausgedrückt wird, wobei die genannte Anordnung insbesondere eine Reihenschaltung eines ersten und zweiten Registers (20) bzw. (21) aufweist, damit zu jedem Abtastzeitpunkt an dem Ausgang dieser Register (21) und (20) und am Eingang (10) des ersten Registers aufeinanderfolgende Abtastwerte $x_n$, $x_{n+1}$ bzw. $x_{n+2}$ verfügbar werden und ausserdem Mittel zum Bestimmen des Ausdrucks cos $\phi=(x_n+x_{n+2})/2x_{n+1}$, dadurch gekennzeichnet, dass die Anordnung zum Erhalten einer automatischen Verstärkungsregelungsschaltung eine Amplitudenbestimmungsschaltung aufweist, zusammengesetzt aus:

einem ersten und zweiten Quadrierer (110) und (140) für das Ausgangssignal $x_{n+1}$ des ersten Registers (20) und des Ausgangssignals eines Addierers (40) der Abtastwerte $x_n$ und $x_{n+2}$;

einem ersten Multiplizierer (110) des Ausgangssignals $x_n$ des zweiten Registers (21) mit dem Eingangssignal $x_{n+2}$ des ersten Registers (20);

einem ersten Subtrahierer (120), subtrahierent das Ausgangssignal des ersten Multiplizierers (100) von dem des ersten Quadrierers (110);

einem zweiten Multiplizierer (130) des Ausgangssignals des genannten ersten Quadrierers (110), nach Verschiebung um zwei Bits desselben zum Multiplizieren mit 4, mit dem Ausgangssignal des ersten Subtrahierers (120);

einem zweiten Subtrahierer (150), subtrahierent das Ausgangssignal des ersten Quadrierers (110), nach Verschiebung um zwei Bits desselben zum Multiplizieren mit 4, von dem des zweiten Quadrierers (140), und

einem Teiler (160) des Ausgangssignals des zweiten Multiplizierers (130) durch das Ausgangssignal des zweiten Subtrahierers (150), dieser Teiler lieferent das Quadrat der genannten Amplitude des Eingangssignals.

2. Digitale Anordnung zum Messen der augenblicklichen Frequenz $F_s$ eines frequenzmodulierten Signals nach der Phasenverschiebung $\phi$, in deren Abhängigkeit die genannte augenblickliche Frequenz mittels einer trigoniometrischen Abhängigkeitsbeziehung ausgedrückt wird, wobei die genannte Anordnung insbesondere eine Reihenschaltung eines ersten und zweiten Registers (20) bzw. (21) aufweist, damit zu jedem Abtastzeitpunkt an dem Ausgang dieser Register (21) und (20) und am Eingang (10) des ersten Registers aufeinanderfolgende Abtastwerte $x_n$, $x_{n+1}$ bzw. $x_{n+2}$ verfügbar werden und ausserdem Mittel zum Bestimmen des Ausdrucks cos $\phi=(x_n+x_{n+2})/2x_{n+1}$, dadurch gekennzeichnet, dass die Anordnung zum Erhalten einer automatischen Verstärkungsregelungsschaltung eine Amplitudenbestimmungsschaltung aufweist, zusammengesetzt aus:

einem Multiplizierer (200) für zwei Reihen zusammengestellter Eingangssignale, wobei die eine Reihe die Eingangssignale $x_n$, $x_{n+1}$, $(x_n+x_{n+2})$, $(x^2_{n+1}-x_n \cdot x_{n+2})$ aufweist und die andere Reihe die Eingangssignale $x_{n+1}$, $x_{n+2}$, $(x_n+x_{n+2})$, $x^2_{n+1}$ aufweist und für vier Ausgangssignale $x^2_{n+1}$, $x_n \cdot x_{n+2}$, $(x_n+x_{n+2})^2$ und $4x^2_{n+1} \cdot (x^2_{n+1}-x_n \cdot x_{n+2})$, geliefert durch Multiplexierung und gespeichert in vier Zwischenspeichern (201) bis (204);

einem ersten Subtrahierer (210) zum Berechnen von $(x^2_{n+1}-x_n \cdot x_{n+2})$;

einem zweiten Subtrahierer (220) zum Berechnen von $4x^2_{n+1}-(x_n+x_{n+2})$;

und einem Teiler (230) des Ausgangssignals des vierten Zwischenspeichers (204) durch das Ausgangssignal des zweiten Subtrahierers (220), dieser Teiler lieferent das Quadrat der genannten Amplitude des Eingangssignals.

3. Digitale Anordnung zum Messen der augenblicklichen Frequenz $F_s$ eines frequenzmodulierten Signals nach der Phasenverschiebung φ, in deren Abhängigkeit die genannte augenblickliche Frequenz mittels einer trigoniometrischen Abhängigkeitsbeziehung ausgedrückt wird, wobei die genannte Anordnung insbesondere eine Reihenschaltung eines ersten und zweiten Registers (20) bzw. (21) aufweist, damit zu jedem Abtastzeitpunkt an dem Ausgang dieser Register (21) und (20) und am Eingang (10) des ersten Registers aufeinanderfolgende Abtastwerte $x_n$, $x_{n+1}$ bzw. $x_{n+2}$ verfügbar werden und ausserdem Mittel zum Bestimmen des Ausdrucks cos $φ=(x_n+x_{n+2})/2x_{n+1}$, dadurch gekennzeichnet, dass die Anordnung zum Erhalten einer automatischen Verstärkungsregelungsschaltung eine Amplitudenbestimmungsschaltung aufweist, zusammengesetzt aus:

drei Zusatzregistern (310), (320), (321), lieferent $x_{n+2}$, $x_{n+1}$ bzw. $x_n$;

einem ersten Multiplizierer (330) zum Berechnen von $x_n \cdot x_{n+2}$;

einem Quadrierer (340) für das Ausgangssignal $x_{n+1}$ des zweiten Zusatzregisters (320);

einem Subtrahierer (350) zum Berechnen von $(x^2_{n+1}-x_n \cdot x_{n+2})$;

einem Bezugsspeicher (360), erhaltent das Ausgangssignal cos φ zum Bestimmen des Wertes $1/\sin^2φ$ von jedem Wert von cos φ;

und einem zweiten Multiplizierer (370) des Ausgangssignals des Subtrahierers (350) mit dem des Bezugsspeichers (360), dieser zweite Multiplizierer (370) lieferent das Quadrat der genannten Amplitude des Eingangssignals.

4. Anordnung nach Anspruch 3, dadurch gekennzeichnet, dass der erste Multiplizierer (330), der Quadrierer (340) und der zweite Multiplizierer (370) zu einem einzigen Multiplizierer zusammengefügt sind, der durch Multiplexieren arbeitet.

5. Anordnung nach einem der Ansprüche 1 bis 4, dadurch gekennzeichnet, dass die Amplitudenbestimmungsschaltung aus zwei Zusatzregistern zusammengesetzt ist, zwei aufeinanderfolgende Abtastwerte $x_n$ und $x_{n+1}$ holent um eine langsamere Durchführung der erforderlichen Vorgänge in der Amplitudenstimmungsschaltung zu verwirklichen.

6. Anordnung nach einem der Ansprüche 1 bis 4, dadurch gekennzeichnet, dass die Amplitudenbestimmungsschaltung aus zwei Zusatzregistern zusammengesetzt ist, zwei Abtastwerte $x_n$ und $x_p$ holent, mit irgend einer Phasenverschiebung gleich (p−n), um eine langsamere Durchführung der erforderlichen Vorgänge in der Amplitudenbestimmungsschaltung zu verwirklichen.

**Claims**

1. A digital circuit for measuring the instantaneous frequency $F_s$ of a frequency-modulated signal on the basis of a phase shift φ which is related to said instantaneous frequency in accordance with a trigonometral function, said circuit comprising more specifically first and second registers (20) and (21) arranged in series to ensure that at each sampling instant consecutive samples $x_n$, $x_{n+1}$ and $x_{n+2}$, respectively, be available at the outputs of these registers (21) and (20) and at the input (10) of the first register, and also means for determining the expression cos $φ=(x_n+x_{n+2})/2x_{n+1}$, characterized in that it comprises, to allow the provision of an automatic gain control circuit, an amplitude-determining circuit comprised of:

first and second squaring circuits (110) and (140) for squaring the output signal $x_{n+1}$ of the first register (20) and for the output signal of an adder (40) of the samples $x_n$ and $x_{n+2}$, respectively;

a first multiplier (100) for multiplying the output signal $x_n$ from the second register (21) by the input signal $x_{n+2}$ of the first register (20);

a first subtracter (120) subtracting the output signal from the first multiplier (100) from the output signal from the first squaring circuit (110);

a second multiplier (130) for multiplying the output signal from the first squaring circuit (110), after a shift through two bits for a multiplication by 4, by the output signal from the first subtracter (120);

a second subtracter (150) subtracting the output signal from the first squaring circuit (110), after a shift through two bits for a multiplication by 4, from the output signal from the second squaring circuit (140);

and a divider (160) for dividing the output signal from the second multiplier (130) by the output signal from the second subtracter (150), this divider supplying the square of said amplitude of the input signal.

2. A digital circuit for measuring the instantaneous frequency $F_s$ of a frequency-modulated signal on the basis of a phase shift φ which is related to said instantaneous frequency in accordance with a trigonometrical function, said circuit comprising more specifically first and second registers (20) and (21) arranged in series to ensure that at each sampling instant consecutive samples $x_n$, $x_{n+1}$, $x_{n+2}$, respectively, be available at the outputs of these registers (21) and (20) and at the input (10) of the first register, and also means for determining the expression $\cos \phi = (x_n + x_{n+2})/2x_{n+1}$, characterized in that it comprises, to allow the provision of an automatic gain control circuit, an amplitude-determining circuit comprised of:

a multiplier (200) having two sets of input signals, one set being formed by the input signal $x_n$, $x_{n+1}$, $(x + x_{n+2})$, $(x^2_{n+1} - x_n \cdot x_{n+2})$ and the other set being formed by the input signal $x_{n+1}$, $x_{n+2}$, $(x_n + x_{n+2})$, $x^2_{n+1}$, and having four output signals $x^2_{n+1}$, $x_n \cdot x_{n+2}$, $(x_n + x_{n+2})^2$ and $4x^2_{n+1} \cdot (x^2_{n+1} - x_n \cdot x_{n+2})$ obtained by a multiplexing operation and stored in four intermediate registers (201) to (204), respectively;

a first subtracter (210) for calculating $(x^2_{n+1} - x_n \cdot x_{n+2})$;

a second subtracter (220) for calculating $4x^2_{n+1} - (x_n + x_{n+2})$;

and a divider (230) for dividing the output signal from the fourth intermediate register (204) by the output signal from the second subtracter (220), this divider supplying the square of said amplitude of the input signal.

3. A digital circuit for measuring the instantaneous frequency $F_s$ of a frequency modulated signal on the basis of a phase shift $\phi$ which is related to said instantaneous frequency in accordance with a trigonometrical function, said circuit comprising more specifically first and second registers (20) and (21) arranged in series to ensure that at each sampling instant consecutive samples $x_n$, $x_{n+1}$ and $x_{n+2}$, respectively, be available at the outputs of these registers (21) and (20) and at the input (10) of the first register, and also means to determine the expression $\cos \phi = (x_n + x_{n+2})/2x_{n+1}$, characterized in that it comprises, to allow the provision of an automatic gain control circuit, an amplitude-determining circuit comprised of:

three additional registers (310), (320), (321) supplying $x_{n+2}$ $x_{n+1}$, $x_n$ respectively;

a first multiplier (330) for calculating $x_n \cdot x_{n+2}$;

a squaring circuit (340) for squaring the output signal $x_{n+1}$ of the second additional register (320);

a subtracter (350) for calculating $(x^2_{n+1} - x_n \cdot x_{n+2})$;

a mapping memory (360) receiving the output signal $\cos \phi$ to determine $1/\sin^2\phi$ from each value of $\cos \phi$;

and a second multiplier (370) for multiplying the output signal from the subtracter (350) by the output from the mapping memory (360), the second multiplier (370) supplying the square of said amplitude of the input signal.

4. A circuit as claimed in Claim 3, characterized in that the first multiplier (330), the squaring circuit (340) and the second multiplier (370) are combined to form one single multiplier operating by a multiplexing operation.

5. A circuit as claimed in any one of the Claims 1 to 4, characterized in that the amplitude determining circuit is comprised of two additional registers taking two consecutive samples $x_n$ and $x_{n+1}$ to provide a slower realization of the operations necessary in the amplitude-determining circuit.

6. A circuit as claimed in any one of the Claims 1 to 4, characterized in that the amplitude-determining circuit is comprised of two additional registers taking two samples $x_n$ and $x_p$ of any phase shift equal to $(p-n)$ to provide a slower realization of the operations necessary in the amplitude-determining circuit.

FIG.1

FIG.2

FIG.3

FIG.4

FIG.6

FIG.5

3